(19) Europäisches Patentamt
European Patent Office
Office européen des brevets

(11) **EP 2 042 619 A2**

(12) **EUROPÄISCHE PATENTANMELDUNG**

| | |
|---|---|
| (43) Veröffentlichungstag:<br>**01.04.2009 Patentblatt 2009/14** | (51) Int Cl.:<br>***C23C 16/455*** *(2006.01)*   ***C23C 16/30*** *(2006.01)* |

(21) Anmeldenummer: **08163335.6**

(22) Anmeldetag: **29.08.2008**

| | |
|---|---|
| (84) Benannte Vertragsstaaten:<br>**AT BE BG CH CY CZ DE DK EE ES FI FR GB GR HR HU IE IS IT LI LT LU LV MC MT NL NO PL PT RO SE SI SK TR**<br>Benannte Erstreckungsstaaten:<br>**AL BA MK RS**<br><br>(30) Priorität: **28.09.2007 DE 102007046606**<br>               **20.02.2008 DE 102008010041** | (71) Anmelder: **OSRAM Opto Semiconductors GmbH**<br>**93055 Regensburg (DE)**<br><br>(72) Erfinder: **Behres, Alexander**<br>**93309, Kelheim (DE)**<br><br>(74) Vertreter: **Epping - Hermann - Fischer**<br>**Patentanwaltsgesellschaft mbH**<br>**Ridlerstraße 55**<br>**80339 München (DE)** |

(54) **Beschichtungsvorrichtung und Verfahren zu deren Betrieb**

(57) Eine Schichtabscheidevorrichtung umfasst eine Kammer (10) mit einem Substratträger (12) zur Aufnahme von zumindest einem zu beschichtenden Substrat (13) und einem Prozessgasraum (11), der eine Trennwand (23) umfasst, die ein erstes Segment (21) des Prozessgasraums (11) von einem zweiten Segment (22) des Prozessgasraums (11) trennt. Die Schichtabscheidevorrichtung weist eine Vorrichtung (44) zum Bewegen des Substrates (13) relativ zu der Trennwand (23) auf.

FIG 1A

EP 2 042 619 A2

**Beschreibung**

Diese Patentanmeldung beansprucht die Priorität der deutschen Patentanmeldungen DE 10 2007 046 606.6 und DE 10 2008 010 041.2, deren Offenbarungsgehalte hiermit durch Rückbezug aufgenommen werden.

Die vorliegende Erfindung betrifft eine Schichtabscheidevorrichtung und ein Verfahren zum Betrieb einer Schichtabscheidevorrichtung.

Bei der Abscheidung einer Schicht in einer Schichtabscheidevorrichtung werden üblicherweise die Prozessgase, die zur Herstellung der Schicht benötigt werden, gleichzeitig stationär über ein zu beschichtendes Substrat geleitet. Dies kann zu Vorreaktionen in der Gasphase führen. Durch die Vorreaktionen werden Partikel in einem Prozessgasraum erzeugt, die sich auf dem Substrat anordnen können.

Dokument US 6,576,062 B2 befasst sich mit einer Schichtabscheidevorrichtung mit einer ersten und einer zweiten Gaszuführung.

Aufgabe der Erfindung ist es, eine Schichtabscheidevorrichtung und ein Verfahren zum Betrieb einer Schichtabscheidevorrichtung bereitzustellen, welche eine Vorreaktion von Prozessgasen verringern.

Diese Aufgabe wird mit dem Gegenstand mit den Merkmalen des Anspruchs 1 sowie mit dem Verfahren gemäß Patentanspruch 15 gelöst. Weiterbildungen und Ausgestaltungen sind jeweils Gegenstand der abhängigen Ansprüche.

In einer Ausführungsform weist eine Schichtabscheidevorrichtung eine Kammer auf. Die Kammer umfasst einen Substratträger zur Aufnahme von einem zu beschichtenden Substrat und einen Prozessgasraum. Der Prozessgasraum weist ein erstes und ein zweites Segment sowie eine Trennwand auf. Die Trennwand trennt das erste Segment und das zweite Segment voneinander. Weiter umfasst die Schichtabscheidevorrichtung eine Vorrichtung zum Bewegen des Substrates relativ zu der Trennwand.

Mit Vorteil ist die Trennwand zwischen dem ersten und dem zweiten Segment angeordnet, so dass erste Prozessbedingungen im ersten Segment unabhängig von zweiten Prozessbedingungen im zweiten Segment eingestellt werden können. Somit werden Vorreaktionen von Prozessgasen verringert. Unter einem Gas wird hierbei auch ein Plasma verstanden. In einer Ausführungsform kann mittels der Vorrichtung zum Bewegen des Substrates der Substratträger relativ zu der Trennwand bewegt werden. Der Substratträger kann derart bewegt werden, dass das zu beschichtende Substrat vom ersten Segment in das zweite Segment bewegt werden kann, so dass das Substrat abwechselnd und nacheinander mittels der ersten und der zweiten Prozessbedingungen beschichtet werden kann.

In einer Ausführungsform umfasst die Kammer eine erste Gaszuführung in das erste Segment und eine zweite Gaszuführung in das zweite Segment. Mit Vorteil können mittels der ersten und der zweiten Gaszuführung ein erstes Prozessgas in das erste Segment und ein zweites Prozessgas in das zweite Segment eingeleitet werden. Das erste und das zweite Prozessgas sind bevorzugt unterschiedlich. Durch die Trennwand wird das erste Segment von dem zweiten Segment derart abgetrennt, dass vorteilhafterweise sich das erste Prozessgas nicht mit dem zweiten Prozessgas mischt, so dass Vorreaktionen der beiden Prozessgase vermieden werden.

In einer Ausführungsform ist die Schichtabscheidevorrichtung zur chemischen Abscheidung aus der Gasphase, englisch chemical vapor deposition, abgekürzt CVD, ausgebildet. Bevorzugt ist die Schichtabscheidevorrichtung als Epitaxieschichtabscheidevorrichtung realisiert. Die Schichtabscheidevorrichtung kann für ein Atomlagenepitaxieverfahren, englisch atomic layer epitaxy, realisiert sein. Die Schichtabscheidevorrichtung kann somit zum Abscheiden von Verbindungshalbleitern verwendet werden. Dabei kann beispielsweise eine Atomlage einer ersten Komponente des Verbindungshalbleiters im ersten Segment und eine Atomlage einer zweiten Komponente des Verbindungshalbleiters im zweiten Segment abgeschieden werden. Bevorzugt befindet sich das Substrat mehrfach abwechselnd im ersten und im zweiten Segment, so dass eine eine Vielzahl von Atomlagen aufweisende Schicht abgeschieden werden kann.

In einer Ausführungsform ist der Substratträger als kreisförmiger Teller ausgebildet. Der kreisförmige Teller weist eine Rotationssymmetrieachse auf. Der Substratträger und der Prozessgasraum sind gegeneinander rotierbar angeordnet. Dabei kann eine Rotationsachse der Relativbewegung die Rotationssymmetrieachse des Tellers sein. Bevorzugt ist das Substrat außerhalb der Rotationsymmetrieachse des Tellers und damit außerhalb der Rotationsachse angeordnet.

In einer Ausführungsform ist der Substratträger zur Aufnahme von einer Mehrzahl von zu beschichtenden Substraten ausgelegt.

In einer Ausführungsform ist der Substratträger als Gaskissen aus dem Prozessgas oder einem Trägergas ausgebildet, auf dem das zumindest eine Substrat schwebt. Das Gaskissen kann derartig ausgebildet sein, dass das zumindest eine Substrat in eine Rotationsbewegung versetzt wird.

In einer Ausführungsform ist der Prozessgasraum im Wesentlichen zylinderförmig. Bevorzugt verläuft die Trennwand durch eine Mittelachse des Zylinders. Die Mittelachse kann die Rotationsachse sein. Die Trennwand kann im Wesentlichen als Rechteck ausgebildet sein. Alternativ umfasst die Trennwand ein oder mehrere Rechtecke. Die Trennwand kann als mechanische Trennwand ausgebildet sein. Die Trennwand kann als Festkörper realisiert sein. Die Trennwand kann ein gasundurchlässiges Material enthalten. Ein Material der Trennwand kann wärmeresistent sein. Das Material kann bis zu einer Temperatur von 1000 Grad Celsius temperaturstabil sein. Alternativ kann das Material bis zu einer Temperatur von 2000 Grad Celsius temperaturstabil sein. Das Material kann porös sein. Das Material kann Keramik, Edelstahl oder Molybdän enthalten.

In einer Ausführungsform teilt die Trennwand den zylinderförmigen Prozessgasraum derart, dass das erste Segment und das zweite Segment gleich groß sind. In einer alternativen Ausführungsform sind das erste und das zweite Segment unterschiedlich groß.

In einer Weiterbildung umfasst die Vorrichtung zum Bewegen des Substratträgers relativ zu der Trennwand einen Motor. Das Substrat kann in einem ersten Betriebszustand im ersten Segment und in einem zweiten Betriebszustand im zweiten Segment angeordnet sein.

Bevorzugt ist der Substratträger beweglich gegenüber der Kammer angeordnet. Damit ist der Substratträger beweglich gegenüber dem Prozessgasraum. In dieser Ausführungsform sind die Trennwand sowie die erste und die zweite Gaszuführung fest mit der Kammer verbunden.

In einer Ausführungsform weist die Trennwand einen Abstand zu dem Substratträger auf. Der Abstand kann einen Wert kleiner 20 mm aufweisen. Alternativ kann der Abstand einen Wert kleiner 5 mm aufweisen. Bevorzugt kann der Abstand einen Wert zwischen 1 mm und 0,1 mm aufweisen. Mit Vorteil ist somit ausschließlich ein kleiner Spalt zwischen dem Substratträger und der Trennwand vorhanden, durch den allenfalls ein geringer Gasaustausch zwischen dem ersten und dem zweiten Segment möglich ist.

In einer Ausführungsform sind eine Oberfläche des Substratträgers und eine Oberfläche des Substrats in einer gemeinsamen Ebene angeordnet. Mit Vorteil bildet somit die Trennwand einen Spalt mit einem konstanten Abstand sowohl gegenüber dem Substratträger als auch gegenüber dem Substrat. Aufgrund der Rotation des Substratträgers durchläuft das Substrat nacheinander das erste und das zweite Segment, wobei beim Passieren der Trennwand die Gasphase über dem Substrat bis auf einen kleinen Rest abgeschert wird.

In einer Ausführungsform umfasst die Schichtabscheidevorrichtung eine Drehvorrichtung zum Rotieren des Substrats gegenüber dem Substratträger. Mit Vorteil wird somit das Substrat, während es sich beispielsweise im ersten Segment befindet, gedreht, sodass eine Gleichmäßigkeit der Schichtabscheidung erhöht ist.

In einer Ausführungsform umfasst ein Verfahren zum Betrieb einer Schichtabscheidevorrichtung ein Anordnen von mindestens einem zu beschichtenden Substrat auf einem Substratträger. Erste Prozessbedingungen werden in einem ersten Segment eines Prozessgasraums eingestellt. Weiter werden zweite Prozessbedingungen in einem zweiten Segment des Prozessgasraums eingestellt. Dabei trennt eine Trennwand das erste Segment von dem zweiten Segment. Das Substrat wird relativ zu der Trennwand bewegt.

Mit Vorteil können die ersten und die zweiten Prozessbedingungen im ersten und im zweiten Segment unterschiedlich und getrennt voneinander eingestellt werden, so dass Vorreaktionen verringert werden. Das Substrat kann dadurch bewegt werden, dass der Substratträger bewegt wird.

In einer Ausführungsform wird zum Einstellen der ersten Prozessbedingungen ein erstes Prozessgas in das erste Segment eingeleitet. Ein zweites Prozessgas wird in das zweite Segment zum Einstellen der zweiten Prozessbedingungen eingeleitet. Das erste Prozessgas ist bevorzugt verschieden von dem zweiten Prozessgas. Durch die Trennwand wird vorteilhafterweise ein Vermischen des ersten Prozessgases im ersten Segment mit dem zweiten Prozessgas im zweiten Segment verringert, sodass Vorreaktionen des ersten Prozessgases mit dem zweiten Prozessgas reduziert sind.

In einer Ausführungsform wird eine Epitaxieschicht auf dem Substrat abgeschieden. Die Epitaxieschicht kann als Verbindungshalbleiter ausgebildet sein. Dabei kann das erste Prozessgas eine erste Komponente des Verbindungshalbleiters und das zweite Prozessgas eine zweite Komponente des Verbindungshalbleiters aufweisen.

Das Substrat wird bevorzugt mehrfach alternierend dem ersten und dem zweiten Segment des Prozessgasraums ausgesetzt. Mit Vorteil kann somit atomlagenweise eine Epitaxieschicht abgeschieden werden. Eine erste Expositionszeit des Substrats im ersten Segment und eine zweite Expositionszeit des Substrats im zweiten Segment können vorteilhafterweise durch Festlegung einer Rotationsdauer eines Substratträgers, welcher zur Aufnahme des Substrats ausgelegt ist, eingestellt werden. Somit kann mit Vorteil erzielt werden, dass das Substrat dem ersten Prozessgas und dem zweiten Prozessgas jeweils nur für eine kurze Dauer ausgesetzt sind.

Die Rotationsdauer kann kleiner 30 Sekunden sein. Weitergehend kann die Rotationsdauer kleiner 0,1 Sekunden sein. Bevorzugt kann die Rotationsdauer kleiner 10 Sekunden sein.

In einer Ausführungsform umfasst das erste Prozessgas ein erstes Trägergas und das zweite Prozessgas ein zweites Trägergas. Das erste Trägergas kann verschieden von dem zweiten Trägergas sein, sodass ein für die jeweilige Komponente des Verbindungshalbleiters geeignetes Trägergas ausgewählt werden kann.

Der Verbindungshalbleiter kann auf einem III-V-Verbindungshalbleiter oder auf einem II-VI-Verbindungshalbleiter basieren. Der III-V-Verbindungshalbleiter kann auf einem Nitrid-Verbindungshalbleiter, einem Phosphid-Verbindungshalbleiter, einem Antimonid-Verbindungshalbleiter, einem Arsenid-Verbindungshalbleiter oder aus einer Legierung daraus basieren.

"Auf Nitrid-Verbindungshalbleitern basierend" bedeutet im vorliegenden Zusammenhang, dass die aktive Epitaxie-Schichtenfolge oder zumindest eine Schicht davon ein Nitrid-III-Verbindungshalbleitermaterial, vorzugsweise

$Al_nGa_mIn_{1-n-m}N$ umfasst, wobei $0 \leq n \leq 1$, $0 \leq m \leq 1$ und $n+m \leq 1$. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des $Al_nGa_mIn_{1-n-m}N$-Materials im Wesentlichen nicht ändern. Der Einfachheit halber beinhaltet obige Formel jedoch nur die wesentlichen Bestandteile des Kristallgitters Al, Ga, In, N, auch wenn diese teilweise durch geringe Mengen weiterer Stoffe ersetzt sein können.

"Auf Phosphid-Verbindungshalbleitern basierend" bedeutet in diesem Zusammenhang, dass der Halbleiterkörper, insbesondere der aktive Bereich vorzugsweise $Al_nGa_mIn_{1-n-m}P$ umfasst, wobei $0 \leq n \leq 1$, $0 \leq m \leq 1$ und $n+m \leq 1$ ist, vorzugsweise mit $n \neq 0$ und/oder $m \neq 0$. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters Al, Ga, In, P, auch wenn diese teilweise durch geringe Mengen weiterer Stoffe ersetzt sein können.

"Auf Antimonid-Verbindungshalbleitern basierend" bedeutet in diesem Zusammenhang, dass der Halbleiterkörper, insbesondere der aktive Bereich vorzugsweise $Al_nIn_mGa_{1-n-m}Sb$ umfasst, wobei $0 \leq n \leq 1$, $0 \leq m \leq 1$ und $n+m \leq 1$ ist. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters Al, In, Ga, Sb, auch wenn diese teilweise durch geringe Mengen weiterer Stoffe ersetzt sein können.

"Auf Arsenid-Verbindungshalbleitern basierend" bedeutet in diesem Zusammenhang, dass der Halbleiterkörper, insbesondere der aktive Bereich vorzugsweise $Al_nIn_mGa_{1-n-m}As$ umfasst, wobei $0 \leq n \leq 1$, $0 \leq m \leq 1$ und $n+m \leq 1$ ist. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters Al, In, Ga, As, auch wenn diese teilweise durch geringe Mengen weiterer Stoffe ersetzt sein können.

"Auf II-VI-Verbindungshalbleitern basierend" bedeutet in diesem Zusammenhang, dass der Halbleiterkörper, insbesondere der aktive Bereich, eine Verbindung mindestens einer Komponente aus der zweiten Hauptgruppe des Periodensystems, insbesondere Beryllium, Magnesium, Zink, Cadmium und Quecksilber, mit mindestens einer Komponente aus der sechsten Hauptgruppe, insbesondere Sauerstoff, Schwefel, Selen und Tellur, aufweist. Der II-VI-Verbindungshalbleiter kann vorzugsweise $Zn_nCd_{1-n}S_mSe_{1-m}$ umfassen, wobei $0 \leq n \leq 1$ und $0 \leq m \leq 1$ ist. Dabei muss dieses Material nicht zwingend eine mathematisch exakte Zusammensetzung aufweisen. Vielmehr kann es ein oder mehrere Dotierstoffe sowie zusätzliche Bestandteile aufweisen, die die physikalischen Eigenschaften des Materials im wesentlichen nicht ändern. Der Einfachheit halber beinhaltet obige Formel jedoch nur die wesentlichen Bestandteile des Kristallgitters Zn, Cd, S, Se, auch wenn diese teilweise durch geringe Mengen weiterer Stoffe ersetzt sein können. Die II-VI Verbindungshalbleiter können beispielsweise Sulfide und/oder Selenide umfassen.

Der Verbindungshalbleiter kann zur Herstellung einer Leuchtdiode, insbesondere eines Dünnfilm-Leuchtdioden-Chips, eines Lasers, einer Solarzelle oder eines Detektors abgeschieden werden.

Die Erfindung wird nachfolgend an mehreren Ausführungsbeispielen anhand der Figuren näher erläutert. Funktionsbeziehungsweise wirkungsgleiche Komponenten und Bauteile tragen gleiche Bezugszeichen. Insoweit sich Komponenten oder Bauteile in ihrer Funktion entsprechen, wird deren Beschreibung nicht in jeder der folgenden Figuren wiederholt.

Es zeigen:

Figuren 1A bis 1F    jeweils eine beispielhafte Ausführungsform einer Schichtabscheidevorrichtung nach dem vorgeschlagenen Prinzip,

Figur 2    eine alternative beispielhafte Ausführungsform einer Schichtabscheidevorrichtung nach dem vorgeschlagenen Prinzip und

Figuren 3A bis 3D    beispielhafte Komponenten einer Schichtabscheidevorrichtung nach dem vorgeschlagenen Prinzip.

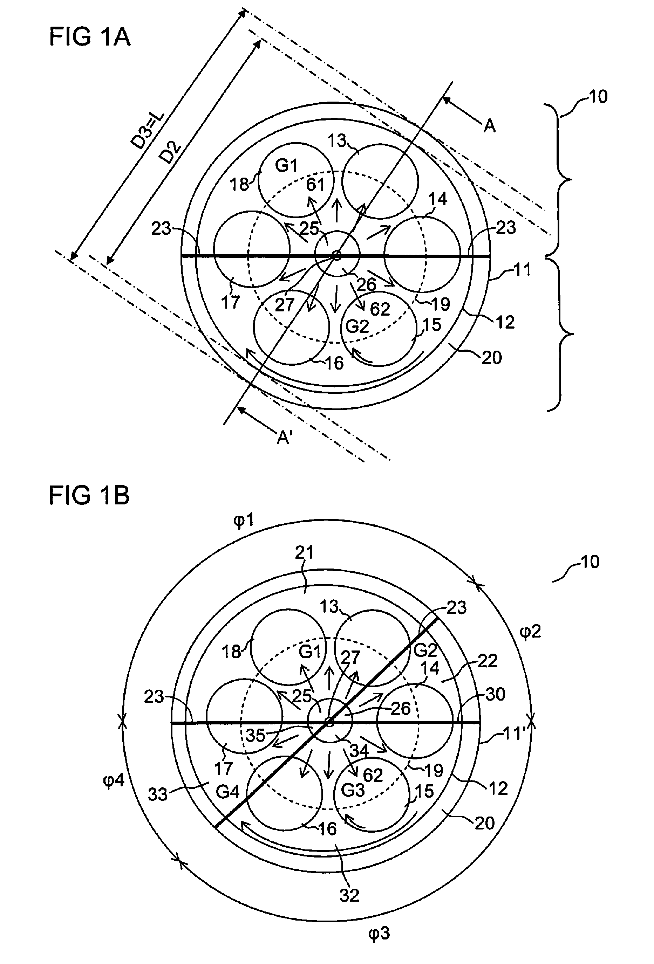

Figur 1A zeigt eine beispielhafte Ausführungsform einer Schichtabscheidevorrichtung nach dem vorgeschlagenen Prinzip in Aufsicht. Die Schichtabscheidevorrichtung umfasst eine Kammer 10 mit einem Prozessgasraum 11 und einem Substratträger 12. Der Substratträger 12 ist als kreisförmiger Teller ausgeführt. Eine Mittelachse des Prozessgasraums 11 entspricht einer Rotationssymmetrieachse 27 des Substratträgers 12. Auf dem Substratträger 12 sind ein erstes zu beschichtendes Substrat 13 sowie fünf weitere zu beschichtende Substrate 14 bis 18 angeordnet. Die sechs zu beschichtenden Substrate 13 bis 18 sind auf dem Substratträger 12 angeordnet. Ein Mittelpunkt des ersten Substrats 13 liegt auf einer Kreislinie 19, deren Mittelpunkt in der Rotationssymmetrieachse 27 des Substratträgers 12 liegt. Ebenfalls liegen die Mittelpunkte der weiteren Substrate 14 bis 18 auf der Kreislinie 19.

Der Prozessgasraum 11 ist im Wesentlichen zylinderförmig ausgebildet. Ein Durchmesser D2 des Substratträgers 12 ist kleiner als ein Durchmesser D3 des Prozessgasraums 11. Daher weist die Kammer 10 einen Spalt 20 zwischen dem Substratträger 12 und einer Wand des Prozessgasraums 11 auf. Der Prozessgasraum 11 umfasst ein erstes Segment 21 und ein zweites Segment 22, das vom ersten Segment durch eine Trennwand 23 getrennt ist. Die Trennwand 23 verläuft durch die Mittelachse des Prozessgasraums 11 und durch die Rotationssymmetrieachse 27 des Substratträgers 12. Die Trennwand 23 erstreckt sich von einem Abschnitt der Wand des Prozessgasraums 11 zu einem gegenüberliegenden Abschnitt der Wand des Prozessgasraums 11. Eine Länge L der Trennwand 23 ist somit der Durchmesser D3 des Prozessgasraums 11. Weiter weist der Prozessgasraum 11 eine erste und eine zweite Gaszuführung 25, 26 auf. Die erste Gaszuführung 25 hat einen Auslass in das erste Segment 21. Entsprechend hat die zweite Gaszuführung 26 einen Auslass in das zweite Segment 22. Der Spalt 20 ist mit einem in Figur 1A nicht gezeigten Vakuumsystem 24 verbunden. Der Spalt 20 dient zur Gasabsaugung.

Zum Abscheiden einer Schicht wird zunächst die Kammer 10 geöffnet. Die zu beschichtenden Substrate 13 bis 18 werden auf dem Substratträger 12 angeordnet. Nach dem Schließen der Kammer 10 wird mittels des Vakuumsystems 24 ein Unterdruck im Prozessgasraum 11 erzeugt. Mittels eines in Figur 1A nicht gezeigten Gasversorgungssystems 28 werden über die beiden Gaszuführungen 25, 26 zuerst Spülgase in das erste und das zweite Segment 21, 22 des Prozessgasraums 11 eingeleitet. Anschließend wird der Substratträger 12 um die Rotationssymmetrieachse 27 entsprechend dem in Figur 1A gezeigten Pfeil gedreht. Dabei berührt die Trennwand 23 den Substratträger 12 sowie die Substrate 13 bis 19 nicht. Das erste Substrat 13, das sich gemäß Figur 1A im ersten Segment 21 befindet, wird in das zweite Segment 22 bewegt. Weiter leitet die erste Gaszuführung 25 ein erstes Prozessgas G1 in das erste Segment 21. Entsprechend leitet die zweite Gaszuführung 26 ein zweites Prozessgas G2 in das zweite Segment 22. Mittels des ersten Prozessgases G1 wird eine erste Schicht auf dem Substrat 13 abgeschieden. Nach dem Drehen des ersten Substrats 13 von dem ersten Segment 21 in das zweite Segment 22 wird mittels des zweiten Prozessgases G2 eine zweite Schicht auf dem Substrat 13 abgeschieden. Das erste Substrat 13 befindet sich alternierend im ersten und im zweiten Segment 21, 22, sodass eine gewünschte Schichtenfolge auf dem ersten Substrat 13 abgeschieden wird. Beispielsweise kann mittels des ersten Prozessgases G1 eine Monolage von Atomen einer ersten Komponente eines Verbindungshalbleiters und mittels des zweiten Prozessgases G2 eine Monolage von Atomen einer zweiten Komponente des Verbindungshalbleiters abgeschieden werden.

Mit Vorteil können mittels der Trennwand zwei Segmente 21, 22 mit unterschiedlichen Prozessbedingungen erzielt werden. Damit ist eine hohe Flexibilität bei der Abscheidung von Schichten möglich. Mit Vorteil verhindert die Trennwand 23 eine Vermischung des ersten Prozessgases G1 mit dem zweiten Prozessgas G2.

In einer alternativen, nicht gezeigten Ausführungsform ist der Substratträger 12 zur Aufnahme von zusätzlichen Substraten ausgebildet. Die zusätzlichen Substrate können entlang einer weiteren Kreislinie um die Rotationssymmetrieachse 27 des Substratsträgers 12 angeordnet sein. Somit ist die Kapazität der Schichtabscheidevorrichtung erhöht.

In einer alternativen, nicht gezeigten Ausführungsform ist der Substratträger 12 zur Aufnahme von Substraten derart ausgebildet, dass die Substrate nicht auf Kreislinien angeordnet sind. Beispielsweise können die Substrate gemäß dem Prinzip der dichtesten Kugelpackung angeordnet sind.

In einer alternativen, nicht gezeigten Ausführungsform ist ein einzelnes Substrat 13 auf dem Substratträger 12 angeordnet. Das Substrat 13 kann sich gleichzeitig im ersten und im zweiten Segment 21, 22 befinden. Das Substrat 13 kann einen Wert für einen Durchmesser aufweisen, der größer 200 mm ist. In einer Ausführungsform kann der Substratträger 12 als Gaskissen ausgebildet sein, auf dem das Substrat 13 schwebt.

In einer alternativen, nicht gezeigten Ausführungsform ist die Schichtabscheidevorrichtung als Atmosphärendruck-Reaktor ausgebildet. Dabei ist in der Kammer 10 ein leichter Überdruck vorhanden. Der Überdruck kann einen Wert aus einem Intervall zwischen 1 mbar und 2 bar annehmen.

In einer alternativen, nicht gezeigten Ausführungsform ist für die Segmente 21, 22 jeweils eine Absaugeinrichtung vorhanden.

Figur 1B zeigt eine weitere beispielhafte Ausführungsform einer Schichtabscheidevorrichtung nach dem vorgeschlagenen Prinzip. Die Schichtabscheidevorrichtung gemäß Figur 1B ist eine Weiterbildung der in Figur 1A dargestellten Schichtabscheidevorrichtung. Gemäß Figur 1B umfasst der Prozessgasraum 11' eine zweite und eine dritte Trennwand 30, 31, sodass der Prozessgasraum 11' ein drittes und ein viertes Segment 32, 33 umfasst. Die vier Segmente 21, 22, 32, 33 sind unterschiedlich groß. Mittels der Trennwände 23, 30, 31 wird somit der zylinderförmige Prozessgasraum 11' in vier Teile geteilt. Dabei ist eine Fläche des ersten Segments 21 des in Figur 1B gezeigten Querschnitts proportional zu einem ersten Winkel $\varphi 1$, eine Fläche des zweiten Segments proportional zu einem zweiten Winkel $\varphi 2$, eine Fläche des dritten Segments 32 proportional zu einem dritten Winkel $\varphi 3$ und eine Fläche des vierten Segments 33 proportional zu einem vierten Winkel $\varphi 4$. Darüber hinaus umfasst die Kammer 10 eine dritte Gaszuführung 34 in das dritte Segment 32 zur Zuleitung eines dritten Prozessgases G3 und eine vierte Gaszuführung 35 in das vierte Segment 33 zur Zuleitung eines vierten Prozessgases G4.

Die dritte Gaszuführung 34 beaufschlagt das dritte Segment 32 mit dem dritten Prozessgas G3. Entsprechend beaufschlagt die vierte Gaszuführung G4 das vierte Segment 33 mit dem vierten Prozessgas G4. Zum Abscheiden einer Schicht können somit die vier Segmente 21, 22, 32, 33 mit unterschiedlichen Gasen beaufschlagt werden. Beispielsweise können das erste und das dritte Segment 21, 32 mit Gasen, die Komponenten der Schicht enthalten, sowie das zweite und das vierte Segment 22, 33 mit Spülgasen beaufschlagt werden. Ein Spülgas kann beispielsweise Stickstoff oder Argon sein. Der Substratträger 12 bewegt sich mit einer Rotationsdauer T. Somit befindet sich das erste Substrat 13 während einer ersten Dauer T1, die als Expositionszeit bezeichnet werden kann, gemäß folgender Gleichung im ersten Segment 21:

$$T1 = \frac{\varphi 1}{360^o} \cdot T,$$

wobei φ1 ein Winkel des ersten Segments 21 ist. Die Trennwand 23 ist auf den beiden Schenkeln des Winkels φ1 angeordnet. Entsprechend befindet sich das erste Substrat 13 für eine zweite Zeitdauer T2 im zweiten Segment 22, für eine dritte Zeitdauer T3 im dritten Segment 30 und für eine vierte Zeitdauer T4 im vierten Segment 33 gemäß folgenden Gleichungen:

$$T2 = \frac{\varphi 2}{360^o} \cdot T, \quad T3 = \frac{\varphi 3}{360^o} \cdot T, \quad T4 = \frac{\varphi 4}{360^o} \cdot T$$

*mit* φ1+φ2+φ3+φ4=360° *und* T1+T2+T3+T4=T

Mit Vorteil wird eine Vermischung des ersten Prozessgases G1, das sich im ersten Segment 21 befindet, mit dem dritten Prozessgas G3, das sich im dritten Segment 32 befindet, weiter verringert. Mit Vorteil können somit mittels der Lage der Trennwände 23, 30, 31 die Expositionszeiten des ersten Substrats 13 in den einzelnen Segmenten festgelegt werden. Somit sind die Expositionszeiten für das Beaufschlagen mit dem ersten Prozessgas G1, für das Spülen nach dem Beaufschlagen mit dem ersten Prozessgas G1, für das Beaufschlagen mit dem dritten Prozessgas G3 und für das Spülen nach dem Beaufschlagen mit dem dritten Prozessgas G3 einzeln einstellbar. Die Expositionszeiten T1 bis T4 können beispielsweise zwischen 0,01 und 10 Sekunden sein.

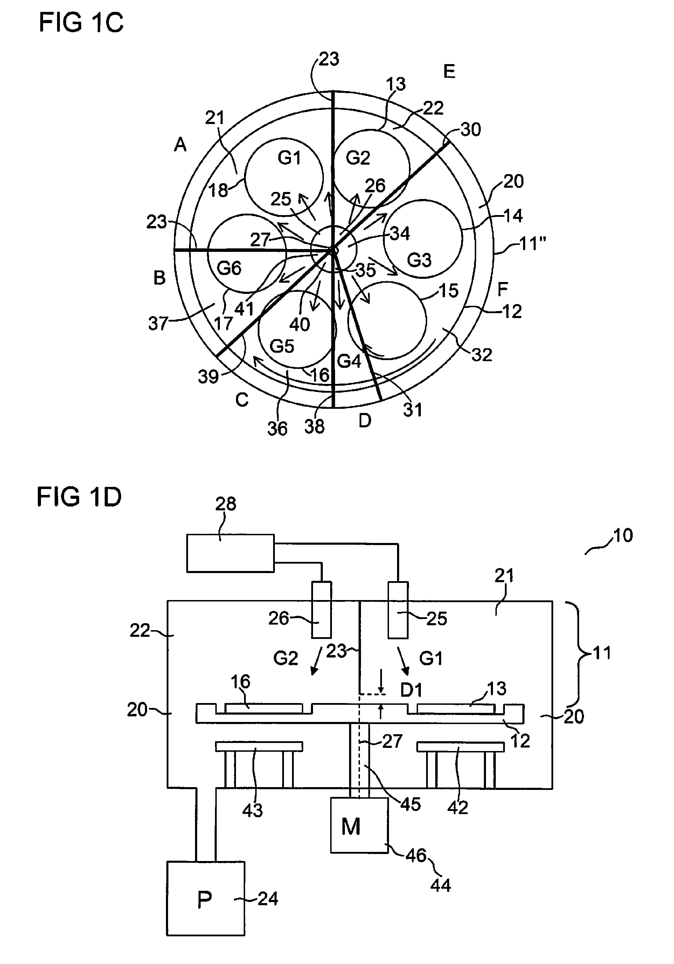

Figur 1C zeigt eine weitere beispielhafte Ausführungsform einer Schichtabscheidevorrichtung nach dem vorgeschlagenen Prinzip. Die Schichtabscheidevorrichtung gemäß Figur 1C ist eine Weiterbildung der in Figuren 1A und 1B dargestellten Ausführungsformen. Der Prozessgasraum 11'' gemäß Figur 1C umfasst sechs Segmente. Das Substrat 13 durchläuft nacheinander das erste Segment 21, das zweite Segment 22, das dritte Segment 32, das vierte Segment 33, ein fünftes Segment 36 und ein sechstes Segment 37. Der Prozessgasraum 11'' umfasst somit eine vierte und eine fünfte Trennwand 38, 39.

Die vierte Trennwand 38 ist zwischen dem vierten Segment 33 und dem fünften Segment 36 und die fünfte Trennwand 39 ist zwischen dem fünften Segment 36 und den sechsten Segment 37 angeordnet. Darüber hinaus umfasst die Kammer eine fünfte und eine sechste Gaszuführung 40, 41 in das fünfte beziehungsweise in das sechste Segment 36, 37.

Das Substrat 13 wird somit nacheinander mit sechs verschiedenen Prozessgasen G1 bis G6 in folgender Reihenfolge beaufschlagt:

G1: Gruppe-III-Komponente des Verbindungshalbleiters mit wasserstoffträgergas,
G2: Stickstoffträgergas,
G3: Gruppe-V-Komponente des Verbindungshalbleiters mit Wasserstoffträgergas,
G4: Wasserstoffträgergas,
G5: Gruppe-III-Komponente des Verbindungshalbleiters mit Stickstoffträgergas,
G6: Dotierstoff mit Wasserstoffträgergas.

Entsprechend den sechs Winkeln φ1 bis φ6 der sechs Segmente 21, 22, 32, 33, 36, 37 können die sechs Expositionszeiten T1 bis T6 für die sechs verschiedenen Prozessgase G1 bis G6 eingestellt werden.

Mit Vorteil wird eine Vermischung des ersten und des fünften Prozessgases G1, G5 mit der Gruppe-III-Komponente mit dem dritten Prozessgas G3 mit der Gruppe-V-Komponente des Verbindungshalbleiters gering gehalten. Für die verschiedenen Komponenten können unterschiedliche Trägergase verwendet werden. Ebenfalls können für dieselben Komponenten unterschiedliche Trägergase eingesetzt werden.

Figur 1D zeigt eine beispielhafte Ausführungsform einer Schichtabscheidevorrichtung im Querschnitt. Figur 1D zeigt einen Querschnitt entlang einer in Figur 1A angegebenen Linie AA'. Die Schichtabscheidevorrichtung gemäß Figur 1D ist als vertikaler Reaktor ausgebildet. Die Schichtabscheidevorrichtung wird daher als vertikaler Reaktor bezeichnet, da die Hauptrichtung der Bewegung der Prozessgase G1, G2 im Prozessgasraum 11 senkrecht zu den Substraten 13, 16 erfolgt.

Das erste und das weitere Substrat 13, 16 liegen in Vertiefungen des Substratträgers 12. Somit bilden eine Oberfläche des Substratträgers 12 und eine Oberfläche der Substrate 13, 16 näherungsweise eine Ebene. Oberhalb des Substratträgers 12 ist der Prozessgasraum 11 angeordnet, der das erste und das zweite Segment 21, 22 umfasst. Die erste und die zweite Gaszuführung 25, 26 sind gegenüber dem Substratträger 12 angeordnet. Die Trennwand 23 ist zwischen dem ersten und dem zweiten Segment 21, 22 angeordnet. Die Trennwand 23 hat einen Abstand D1 zu dem Substratträger 12. Weiter weist die Kammer 10 einen ersten Heizer 42 und einen zweiten Heizer 43 auf. Die beiden Heizer 42, 43 sind unterhalb des Substratträgers 12 angeordnet. Die Schichtabscheidevorrichtung umfasst das Vakuumsystem 24, das mit dem umlaufenden Spalt 20 verbunden ist. Weiter weist die Schichtabscheidevorrichtung eine Vorrichtung 44 zum Bewegen des Substratträgers 12 relativ zu der Trennwand 23 auf. Die Vorrichtung 44 umfasst einen Motor 46. Eine Achse 45 des Motors 46 ist mit dem Substratträger 12 verbunden. Dabei entspricht die Rotationssymmetrieachse 27 des Substratträgers 12 einer Mittelachse der Achse 45. Ferner umfasst die Schichtabscheidevorrichtung ein Gasversorgungssystem 28, das über Zuleitungen mit der ersten Gaszuführung 25 und der zweiten Gaszuführung 26 verbunden ist.

Die Substrate 13, 16 werden auf den Substratträger 12 aufgelegt. Das Vakuumsystem 24 erzeugt einen Unterdruck unterhalb des Substratträgers 12 und im Prozessgasraum 11. Der Absolutdruck im Prozessgasraum 11 kann einen Wert aus einem Intervall zwischen 1 mbar und 1 bar betragen. Mittels des Motors 46 und der Achse 47 kann der Substratträger 12 in eine Rotationsbewegung mit der Rotationsdauer T versetzt werden. Der erste und der zweite Heizer 42, 43 sind zur Heizung der Substrate 13 bis 19 vorgesehen. Somit weisen die Substrate 13 bis 19 eine für den Abscheidevorgang geeignete Temperatur auf. Das Gasversorgungssystem 28 stellt für den Spülschritt Spülgase und während des Abscheidevorgangs das erste und das zweite Prozessgas G1, G2 bereit. In einer Ausführungsform umfasst das erste Prozessgas G1 einen Gruppe-III-Precursor und ein Trägergas sowie das zweite Prozessgas G2 einen Gruppe-V-Precursor und ein Trägergas. Die Beschichtung der Substrate 13, 16 wird von oben durchgeführt. Daher wird eine derartige Schichtabscheidevorrichtung auch als Face-up-Anordnung bezeichnet.

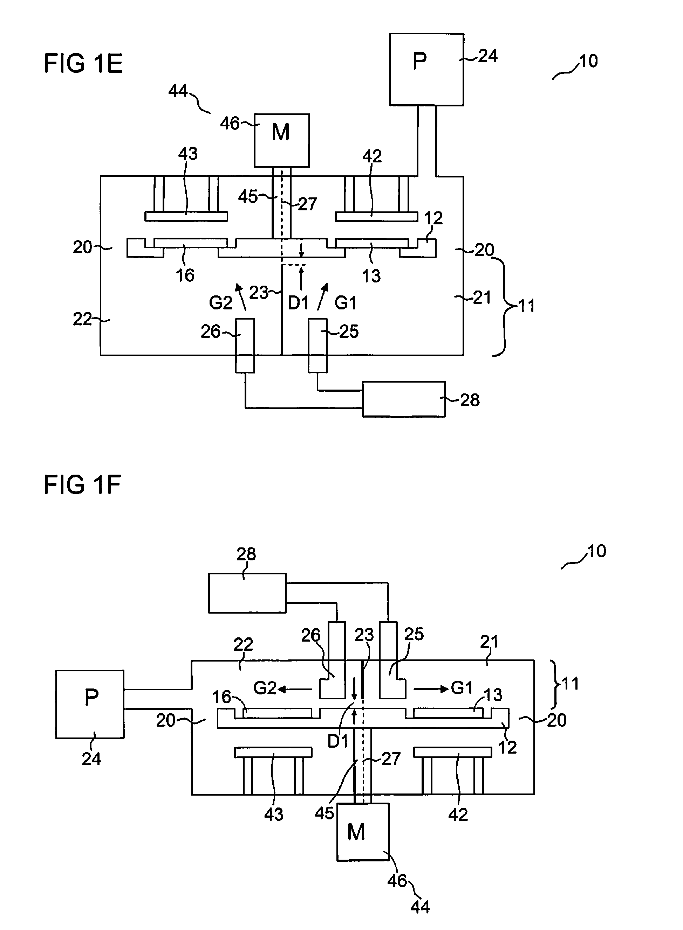

Figur 1E zeigt eine weitere beispielhafte Ausführungsform einer Schichtabscheidevorrichtung im Querschnitt, die eine Weiterentwicklung der in Figur 1D gezeigten Schichtabscheidevorrichtung ist. Die in Figur 1E dargestellte Schichtabscheidevorrichtung ist ebenfalls als vertikaler Reaktor ausgebildet. Die Substrate 13, 16 werden von unten beschichtet. Der Substratträger 12 weist Ausnehmungen auf, auf denen die Substrate 13, 16 liegen, sodass die Substrate 13, 16 von unten durch die Ausnehmungen hindurch beschichtet werden können. Die Substrate 13 bis 19 werden somit mit der zu beschichtenden Seite nach unten in den Substratträger 12 eingelegt. Daher wird eine derartige Schichtabscheidevorrichtung auch als Face-down-Anordnung bezeichnet. Der Prozessgasraum 11 ist somit unterhalb des Substratträgers 12 angeordnet. Die weiteren Komponenten der Schichtabscheidevorrichtung entsprechen den in Figur 1D gezeigten Komponenten, wobei die in Figur 1D oberhalb des Substratträgers 12 angeordneten Komponenten in Figur 1E unterhalb des Substratträgers 12 und die in Figur 1D unterhalb des Substratträgers 12 angeordneten Komponenten in der Schichtabscheidevorrichtung gemäß Figur 1E oberhalb des Substratträgers 12 angeordnet sind. Bei einer Face-down-Anordnung wird vermieden, dass etwaige im Prozessgasraum 11 vorhandene Partikel auf den zu beschichtenden Oberflächen der Substrate 13, 16 auftreffen.

Figur 1F zeigt eine weitere beispielhafte Ausführungsform einer Schichtabscheidevorrichtung im Querschnitt. Die in Figur 1F gezeigte Schichtabscheidevorrichtung ist eine Weiterbildung der Schichtabscheidevorrichtung gemäß Figur 1D. Die in Figur 1F gezeigte Schichtabscheidevorrichtung ist als horizontaler Reaktor realisiert. In dieser Schichtabscheidevorrichtung erfolgt die Hauptbewegung der Prozessgase G1, G2 in horizontaler Richtung, d. h. im Wesentlichen parallel zu der Oberfläche der Substrate 13, 16. Die horizontale Strömung wird durch die Anordnung der Gasauslässe 25, 26 in unmittelbarer Nähe zu der Oberfläche des Substratträgers 12 sowie durch die Absaugung des Prozessgasraums 11 am Rande der Kammer 10 erreicht. Die Schichtabscheidevorrichtung ist als Face-up-Anordnung realisiert.

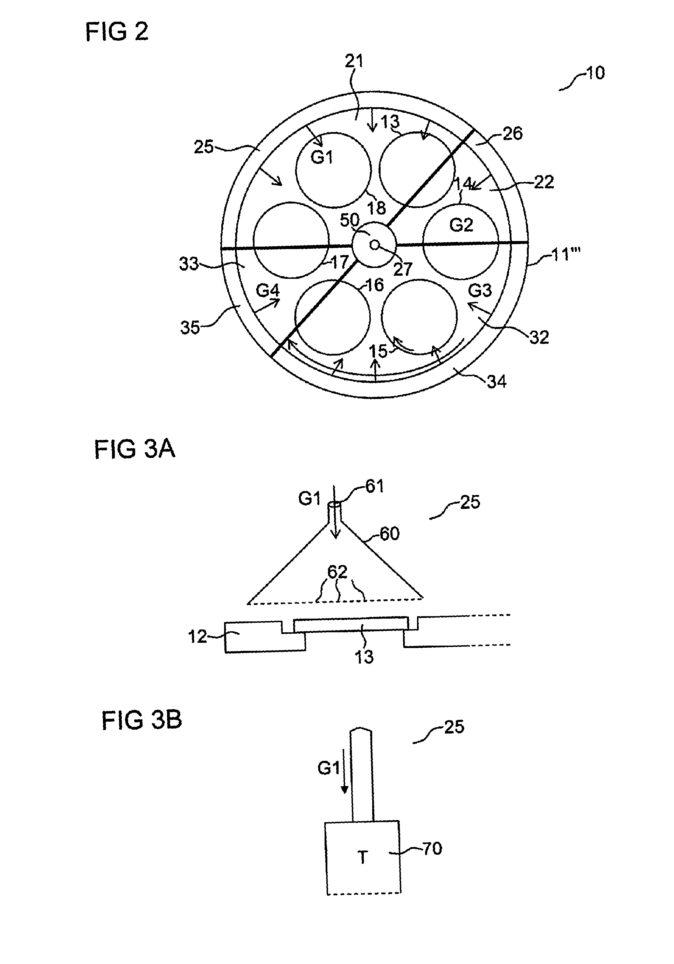

Figur 2 zeigt eine weitere beispielhafte Ausführungsform einer Schichtabscheidevorrichtung nach dem vorgeschlagenen Prinzip. In Figur 2 ist eine Weiterbildung der in Figur 1B dargestellten Ausführungsform gezeigt. Gemäß Figur 2 ist eine Öffnung 50 für die Gasabsaugung in der Mitte des Prozessgasraums 11''' vorgesehen. Die erste Gaszuführung 25 ist an der Wand des Prozessgasraums 11 im ersten Segment 21 angeordnet. Entsprechend ist die zweite, die dritte und die vierte Gaszuführung 26, 34, 35 an der Wand des Prozessgasraums 11''' im zweiten, dritten und vierten Segment 22, 32, 34 angeordnet. Somit bewegen sich die Prozessgase G1 bis G4 ausgehend von der Wand des Prozessgasraums 11''' lateral über die Substrate 13 bis 19 bis in die Mitte des Prozessgasraums 11''', wo sie mittels der Öffnung 50, die zum Vakuumsystem 24 führt, abgesaugt werden.

In Figur 2 ist somit die Flussrichtung der Prozessgase G1 bis G4 gegenüber der Ausführungsform in Figur 1B umgekehrt.

Figur 3A zeigt eine beispielhafte Ausführung einer Gaszuführung. Die Gaszuführung 25 umfasst eine Gasverteilungsvorrichtung 60 mit einem Einlass 61 und mehreren Auslässen 62. Die Auslässe 62 sind gegenüber dem Substratträger 12 angeordnet. Ein Abstand zwischen der Gasverteilungsvorrichtung 60 und dem Substratträger 12 ist gering. Der Abstand beträgt beispielsweise 1 cm. Die Auslässe 62 sind gegenüber dem Bereich des Substratträgers 12 angeordnet, in dem sich nacheinander die verschiedenen Substrate 13 bis 19 befinden.

Mit Vorteil wird mittels der Gasverteilungsvorrichtung 60 eine hohe Homogenität der Gaskonzentration über dem Substrat 13 und damit eine hohe Homogenität der Schichtabscheidung erzielt.

Figur 3B zeigt eine beispielhafte alternative Ausführungsform einer Gaszuführung. Die Gaszuführung 25 umfasst eine Pyrolyse-Vorrichtung 70. Die Pyrolyse-Vorrichtung 70 weist eine Heizquelle auf. Mit der Pyrolyse-Vorrichtung 70 wird das Prozessgas pyrolytisch zersetzt.

Somit kann mit Vorteil eine Vorzerlegung des Prozessgases G1 bereits vor dem Beaufschlagen des Substrates 13 mit dem Prozessgas G1 durchgeführt werden.

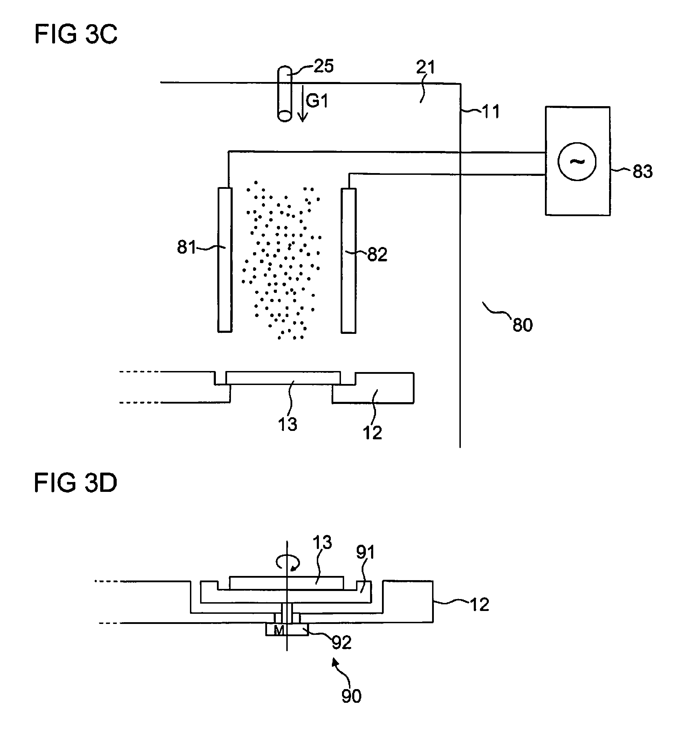

Figur 3C zeigt eine beispielhafte Ausführungsform eines Segments mit einer Vorrichtung 80 zum Erzeugen eines Plasmas. Die Vorrichtung 80 weist eine erste und eine zweite Elektrode 81, 82 auf. Die beiden Elektroden 81 und 82 sind mit einem Wechselspannungsgenerator 83 verbunden, der außerhalb der Kammer 10 angeordnet ist.

Durch Anlegen einer Wechselspannung an die beiden Elektroden 81, 82 wird ein Plasma zwischen den beiden Elektroden 81, 82 und damit in dem Segment erzeugt. Mittels des Plasmas werden Komponenten des Prozessgases G1 des Segments vorzerlegt. Somit ist das Segment für eine Plasmaepitaxie ausgebildet.

Das Plasma kann nahe den Substraten 13 bis 18, insbesondere in einem Abstand von 0,5 bis 2 cm, oder entfernt von den Substraten 13 bis 18 in dem Prozessgasraum 11 erzeugt werden.

Mit Vorteil kann eine Reaktion des Prozessgases G1 mittels des Plasmas bereits vor dem Auftreffen auf dem Substrat ausgeführt werden.

In einer alternativen Ausführungsform kann das Plasma in einer der Gaszuführungen 25, 26, 34, 35, 36, 37 oder in einer der Kammer 10 vorgeschalteten Vorkammer erzeugt werden.

Figur 3D zeigt eine beispielhafte Ausführungsform eines Substratträgers. Gemäß Figur 3D umfasst der Substratträger 12 eine Drehvorrichtung 90. Die Drehvorrichtung 90 weist einen Drehteller 91 zur Aufnahme des Substrats 13 auf. Weiter umfasst die Drehvorrichtung 90 einen Motor 92, dessen Achse mit einer Rotationsachse des Drehtellers 91 verbunden ist.

Mit Vorteil kann somit das Substrat 13 um die Achse des Drehtellers 91 und damit um den Mittelpunkt des Substrats 13 während des Abscheidevorgangs gedreht werden. Mit Vorteil wird somit eine Gleichmäßigkeit der Schichtabscheidung auf dem Substrat 13 erhöht.

In einer alternativen, nicht gezeigten Ausführungsform umfasst der Drehteller 91 Aufnahmen für mehrere Substrate. Somit kann die Kapazität der Schichtabscheidevorrichtung weiter erhöht werden.

In einer alternativen, nicht gezeigten Ausführungsform erfolgt der Antrieb ohne einen Motor. Der Antrieb kann mittels einer Strömung in dem Gaskissen, auf dem der oder die Substrate 13 oder auf dem der Substratträger 12 schwebt, erzeugt werden.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

**Patentansprüche**

1. Schichtabscheidevorrichtung, umfassend

- eine Kammer (10) mit

  - einem Substratträger (12) zur Aufnahme von zumindest einem zu beschichtenden Substrat (13) und
  - einem Prozessgasraum (11), umfassend eine Trennwand (23), die ein erstes Segment (21) des Prozessgasraums (11) von einem zweiten Segment (22) des Prozessgasraums (11) trennt, sowie

- eine Vorrichtung (44) zum Bewegen des zumindest einen Substrates (13) relativ zu der Trennwand (23).

**2.** Schichtabscheidevorrichtung nach Anspruch 1, die Kammer (10) umfassend

- eine erste Gaszuführung (25) in das erste Segment (21) und
- eine zweite Gaszuführung (26) in das zweite Segment (22).

**3.** Schichtabscheidevorrichtung nach Anspruch 2,
bei der der Prozessgasraum (11) mindestens ein weiteres Segment (32, 33, 36, 37) und mindestens eine weitere Trennwand (30, 31, 38, 39) umfasst und die Kammer (10) mindestens eine weitere Gaszuführung (34, 35, 40, 41) in das mindestens eine weitere Segment (32, 33, 36, 37) aufweist.

**4.** Schichtabscheidevorrichtung nach einem der Ansprüche 1 bis 3,
bei der die Schichtabscheidevorrichtung als Epitaxieschichtabscheidevorrichtung ausgebildet ist.

**5.** Schichtabscheidevorrichtung nach einem der Ansprüche 1 bis 4,
bei der der Substratträger (12) als kreisförmiger Teller ausgebildet ist.

**6.** Schichtabscheidevorrichtung nach Anspruch 5,
bei der der Substratträger (12) gegenüber dem Prozessgasraum (11) um eine Achse (45) rotierbar angeordnet ist, welche die Rotationssymmetrieachse des kreisförmigen Tellers ist.

**7.** Schichtabscheidevorrichtung nach einem der Ansprüche 1 bis 6,
bei der die Vorrichtung (44) zum Bewegen des zumindest einen Substrates relativ zu der Trennwand einen Motor (46) umfasst derart, dass das Substrat (13) in einem ersten Betriebszustand in dem ersten Segment (21) und in einem zweiten Betriebszustand in dem zweiten Segment (22) angeordnet ist.

**8.** Schichtabscheidevorrichtung nach einem der Ansprüche 1 bis 7,
bei der die mindestens eine Trennwand (23) einen Abstand D1 zu dem Substratträger (12) aufweist.

**9.** Schichtabscheidevorrichtung nach Anspruch 8,
bei der der Abstand D1 einen Wert kleiner 5 mm aufweist.

**10.** Schichtabscheidevorrichtung nach einem der Ansprüche 1 bis 9,
bei der mindestens eine der Gaszuführungen (25, 26, 34, 35, 40, 41) eine Gasverteilungsvorrichtung (60) mit mehreren Auslässen (62) zum Verteilen eines Prozessgases (G1, G2, G3, G4, G5, G6) im entsprechenden Segment (21, 22, 32, 33, 36, 37) umfasst.

**11.** Schichtabscheidevorrichtung nach einem der Ansprüche 1 bis 10,
umfassend eine Vorzerlegungsstufe zum Zerlegen eines Prozessgases (G1, G2, G3, G4, G5, G6).

**12.** Schichtabscheidevorrichtung nach Anspruch 11,
bei der die Vorzerlegungsstufe als Pyrolyse-Vorrichtung (70) und/oder als Vorrichtung (80) zum Erzeugen eines Plasmas ausgebildet ist.

**13.** Schichtabscheidevorrichtung nach einem der Ansprüche 1 bis 12,
bei der die Kammer (10) eine Drehvorrichtung (90) zum Rotieren des Substrates (13) gegenüber dem Substratträger (12) umfasst.

**14.** Verfahren zum Betrieb einer Schichtabscheidevorrichtung, umfassend

- Anordnen von mindestens einem zu beschichtenden Substrat (13) auf einem Substratträger (12),
- Einstellen von ersten Prozessbedingungen in einem ersten Segment (21) eines Prozessgasraums (11) und Einstellen von zweiten Prozessbedingungen in einem zweiten Segment (22) des Prozessgasraums (11), wobei eine Trennwand (23) das erste Segment (21) von dem zweiten Segment (22) trennt,
- Bewegen des mindestens einen Substrates (13) relativ zu der Trennwand (23).

**15.** Verfahren nach Anspruch 14,
bei dem das Einstellen der ersten Prozessbedingungen ein Zuführen eines ersten Prozessgases (G1) in das erste Segment (21) und das Einstellen der zweiten Prozessbedingungen ein Zuführen eines zweiten Prozessgases (G2) in das zweite Segment (22) umfasst.

FIG 1A

FIG 1B

FIG 1C

FIG 1D

FIG 1E

FIG 1F

## FIG 2

## FIG 3A

## FIG 3B

## FIG 3C

## FIG 3D

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007046606
- DE 102008010041

- US 6576062 B2